# FASCICULE DE BREVET EUROPEEN

(11) **EP 2 126 976 B1**
(45) Date de publication et mention de la délivrance du brevet: **13.06.2012**
(21) Numéro de dépôt: 07847863.3
(22) Date de dépôt: 05.12.2007
(51) Int. Cl.: H01L 51/52, H01L 27/32

(54) **PANNEAU DE DIODES ORGANIQUES ÉLECTROLUMINESCENTES DOTÉ D'ÉLECTRODES INTEGRÉES D'ALIMENTATION SUPÉRIEURE**
TAFEL MIT ORGANISCHEN LICHTEMITTIERENDEN DIODEN MIT INTEGRIERTEN OBEREN VERSORGUNGS-ELEKTRODEN
PANEL OF ORGANIC LIGHT-EMITTING DIODES, PROVIDED WITH INTEGRATED TOP SUPPLY ELECTRODES

(30) Priorité: 07.12.2006 FR 0655381
(43) Date de publication de la demande: 02.12.2009
(73) Titulaire: Thomson Licensing, 92130 Issy-les-Moulineaux (FR)
(72) Inventeur: PRAT, Christophe, 44200 Coueron (FR); VAUFREY, David, 38000 Grenoble (FR); LE ROY, Philippe, 35830 Betton (FR)
(74) Mandataire: Browaeys, Jean-Philippe
(86) Numéro de dépôt international: PCT/EP2007/063375
(87) Numéro de publication internationale: WO 2008/068293

(56) Documents cités:
- US-A1- 2004 256 620
- US-A1- 2005 012 454
- US-A1- 2005 077 816
- US-A1- 2005 179 374

## Description

L'invention concerne la fabrication de panneaux de diodes organiques électroluminescentes comprenant chacune une électrode inférieure et une électrode supérieure ; ces panneaux sont notamment destinés à l'affichage d'images.

Un panneau OLED émettant par le haut requiert une électrode supérieure transparente; cette électrode doit offrir un bon compromis entre transmission optique et conductivité électrique. Pour un panneau à matrice active, l'émission dite vers le haut est fortement recommandée, ne serait ce que parce qu'elle offre la possibilité d'élargir le rapport d'ouverture des pixels et donc d'augmenter la surface globale de la zone émissive. Du fait de la surface de plus en plus élevée des panneaux d'affichage OLED et de la conductivité limitée de l'électrode transparente supérieure, généralement en ITO, des chutes de potentiel se produisent dans cette électrode transparente, qui conduisent à de graves défauts d'uniformité des images affichées. Pour pallier ces défauts, cette électrode supérieure transparente peut être renforcée électriquement par une grille dont les conducteurs opaques sont placés entre les pixels. Un autre moyen de pallier ces défauts est d'insérer des conducteurs de renfort électrique de l'électrode supérieure, soit dans la matrice active du panneau comme décrit dans le document US2004/256620, soit au dessus de la matrice active au même niveau que les électrodes inférieures des diodes comme décrit dans les documents US2005/012454, US2005/077816 et US2005/179374.

Un inconvénient des panneaux décrits dans ces documents est que la surface de contact entre les conducteurs de renfort électrique et les électrodes transparentes n'est pas toujours suffisamment élevée pour assurer un contact électrique satisfaisant, c'est-à-dire offrant une faible résistance.

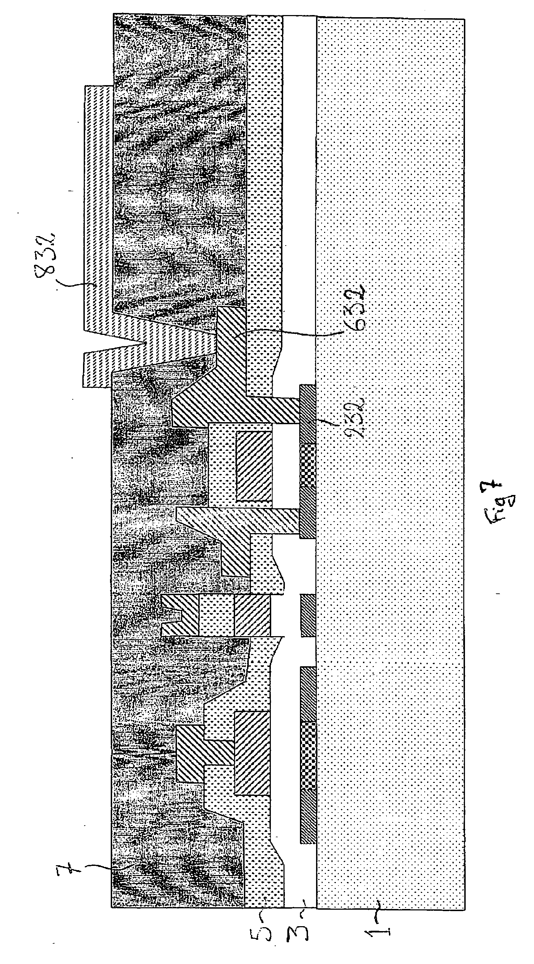

Le document EP1489671 décrit, en référence aux figures 7A à 7F de ce document, un procédé fabrication d'un tel panneau, à renfort électrique intégré à la matrice active, comprenant les étapes dans lesquelles:
- on dépose sur un substrat des moyens d'alimentation inférieure des diodes et un réseau d'électrodes (référencées 324) de distribution pour l'alimentation supérieure des diodes,
- on dépose au moins une couche électriquement isolante (PLN1) sur l'ensemble de la surface active du panneau et on dépose les électrodes inférieures (304-12, 304-22) des diodes de manière à ce qu'elles soient reliées électriquement aux dits moyens d'alimentation inférieure des diodes,
- par ablation dans l'au moins une couche électriquement isolante (7, 9), dégager au moins partiellement les électrodes (324) d'alimentation inférieure des diodes, soit en ménageant des tranchées de connexion, soit en ménageant des séries de trous de connexion (321) le long de ces électrodes (324),
- on dépose au moins une couche organique électroluminescente (EL), en une ou plusieurs zones, de manière à recouvrir l'ensemble de la surface active du panneau y compris lesdites tranchées de connexion ou lesdits trous de connexion (321), et de manière à ce que cette couche (EL) soit en contact direct avec les électrodes inférieures (304-12, 304-22) des diodes,
- on dépose une couche transparente conductrice (340) au moins sur les zones dans lesquelles la couche organique électroluminescente (EL) est en contact direct avec les électrodes inférieures (304-12, 304-22) des diodes, de manière à ce que chaque zone de couche transparente conductrice (340) s'étende jusque dans au moins une desdites tranchées de connexion ou au moins un desdits trous de connexion pour assurer un contact électrique avec au moins une desdites électrodes (62) d'alimentation inférieure des diodes.

Les moyens d'alimentation inférieure des diodes comprennent ici au moins un réseau d'électrodes, dont un réseau d'électrodes d'alimentation inférieure des diodes et, dans le cas présent, des circuits de commande des diodes (301-12, 301-22) comprenant eux-mêmes des éléments tels des transistors et/ou des condensateurs, et des plots conducteurs pour connecter ces éléments.

Le réseau d'électrodes (référencées 324) de distribution pour l'alimentation supérieure des diodes apporte ici le renfort électrique de l'électrode supérieure ; ces électrodes assurent une répartition plus uniforme du potentiel dans les électrodes supérieures des diodes ; comme ces électrodes de renfort sont intégrées à la matrice active, elles limitent très peu la surface émissive du panneau.

Comme illustré à la figure 7E de ce document, ce procédé nécessite une étape d'ablation dans la couche organique électroluminescente entre l'étape de dépôt de la couche électriquement isolante (PLN1) et l'étape de dépôt de la couche transparente conductrice (340), de manière à éviter que la couche organique électroluminescente ne vienne empêcher le contact électrique entre les électrodes 324 et la couche transparente conductrice (340).

Un but de l'invention est d'éviter au moins l'un des inconvénients précités.

A cet effet, un premier objet de l'invention est un procédé de fabrication d'un panneau de diodes organiques électroluminescentes comprenant chacune une électrode inférieure et une électrode supérieure, dans lequel :
- on dépose sur un substrat des moyens d'alimentation inférieure des diodes et un réseau d'électrodes de distribution pour l'alimentation supérieure des diodes,
- on dépose au moins une couche électriquement isolante sur l'ensemble de la surface active du panneau et on dépose les électrodes inférieures des diodes de manière à ce qu'elles soient reliées électriquement aux dits moyens d'alimentation inférieure des diodes,
- par ablation dans l'au moins une couche électriquement isolante, on dégage au moins partiellement les électrodes de distribution pour l'alimentation supérieure, soit en ménageant des tranchées de connexion, soit en ménageant des séries de trous de connexion le long de ces électrodes,
- on dépose au moins une couche organique électroluminescente, en une ou plusieurs zones, de manière à recouvrir l'ensemble de la surface active du panneau y compris lesdites tranchées de connexion ou lesdits trous de connexion, et de manière à ce que cette couche soit en contact direct avec les électrodes inférieures des diodes,
- on dépose une couche transparente conductrice au moins sur les zones dans lesquelles la couche organique électroluminescente est en contact direct avec les électrodes inférieures des diodes, de manière à ce que chaque zone de couche transparente conductrice s'étende jusque dans au moins une desdites tranchées de connexion ou au moins un desdits trous de connexion pour assurer un contact électrique avec au moins une desdites électrodes de distribution pour l'alimentation supérieure des diodes.

Selon l'invention, lesdites électrodes de distribution pour l'alimentation supérieure des diodes présentent des reliefs, notamment des nervures, sur leur face supérieure, au moins au niveau desdites tranchées de connexion ou desdits trous de connexion.

De préférence, lesdites tranchées ou trous de connexion découvrent ces électrodes sur toute leur épaisseur et la largeur desdites tranchées ou trous de connexion, évaluée au fond de ces tranchées et/ou de ces trous, est supérieure d'au moins un tiers à la largeur desdites électrodes, de manière à ménager, de part et d'autre de chaque électrode, des cavités.

En résumé, l'invention a pour objet un procédé de fabrication d'un panneau à matrice active intégrant un réseau d'électrodes de distribution pour l'alimentation supérieure des diodes reliées aux électrodes supérieures transparentes des diodes, dans lequel, entre l'étape de dépôt des couches organiques et celui des électrodes supérieures, on ne procède à aucun décapage de ces couches organiques. Selon l'invention, on parvient à éviter cette étape de décapage grâce à une structuration appropriée, notamment par des nervures et/ou des cavités, qui sont pratiquées à la surface des électrodes de distribution pour l'alimentation supérieure des diodes. On simplifie ainsi le procédé de fabrication des panneaux

Ces nervures et/ou cavités ménagent avantageusement un volume suffisant pour recueillir le matériau de la couche organique lors de son dépôt, permettent de rompre cette couche par endroits, et éviter qu'il ne se dépose sur la face supérieure des électrodes de distribution pour l'alimentation supérieure ; ainsi l'étape d'ablation de la couche organique de l'art antérieur peut être supprimée, puisque la couche organique électroluminescente ne risque plus d'empêcher le contact électrique entre les électrodes de distribution pour l'alimentation supérieure des diodes et la couche transparente conductrice. Avantageusement, le procédé ne comprend pas donc d'étape d'ablation dans la couche organique électroluminescente, notamment entre l'étape de dépôt de l'au moins une couche électriquement isolante et l'étape de dépôt de la couche transparente conductrice.

Un deuxième objet de l'invention est un panneau de diodes organiques électroluminescente, où chaque diode comprend une électrode inférieure et une électrode supérieure, entre lesquelles est insérée un élément de couche organique électroluminescente qui est en contact électrique avec lesdites électrodes, comprenant un substrat supportant :
- des moyens d'alimentation inférieure des diodes reliés électriquement aux électrodes inférieures (832) des diodes, et un réseau d'électrodes (62) de distribution pour l'alimentation supérieure des diodes reliées aux électrodes supérieures de diodes,
- au moins une couche électriquement isolante recouvrant lesdits moyens d'alimentation inférieure des diodes et ledit réseau d'électrodes de distribution pour l'alimentation supérieure des diodes, c'est-à-dire notamment l'ensemble de la surface active du panneau, les électrodes inférieures des diodes étant de préférence reliées électriquement aux dits moyens d'alimentation inférieure des diodes au travers de ladite couche électriquement isolante,
- des tranchées ou des trous de connexion pratiqués dans l'au moins une couche électriquement isolante pour dégager au moins partiellement de ladite couche électriquement isolante les électrodes de distribution pour l'alimentation supérieure des diodes de ladite couche,
- une couche transparente conductrice recouvrant, en une ou plusieurs zones, les zones dans lesquelles la couche organique électroluminescente est en contact électrique, de préférence contact direct, avec les électrodes inférieures des diodes, dont chaque zone s'étend jusque dans au moins une desdites tranchées et/ou au moins un desdits trous de connexion de manière à assurer un contact électrique avec au moins une desdites électrodes de distribution pour l'alimentation supérieure des diodes,
où lesdites électrodes de distribution pour l'alimentation supérieure des diodes présentent des reliefs ou structuration, notamment des nervures, sur la face de ces électrodes de distribution (62) qui est en contact électrique avec ladite couche transparente conductrice (11), c'est-à-dire notamment sur leur face supérieure, au moins au niveau desdites tranchées de connexion et/ou desdits trous de connexion.

La couche organique électroluminescente comprenant les éléments de couches insérés entre les électrodes des diodes recouvre ainsi, en une ou plusieurs zones, l'ensemble de la surface active du panneau, de préférence y compris lesdites tranchées ou lesdits trous de connexion, et est en contact électrique, de préférence direct, avec les électrodes inférieures des diodes.

De préférence, lesdits reliefs sont adaptés, d'une manière connue en elle-même, pour augmenter la surface de contact électrique entre les électrodes de distribution pour l'alimentation supérieure des diodes et la couche transparente conductrice.

De préférence, la profondeur desdits reliefs, notamment des nervures, représente au moins la moitié de l'épaisseur de ladite électrode de distribution pour l'alimentation supérieure des diodes.

Par exemple, dans le cas où les reliefs sont des nervures pratiquées dans lesdites électrodes de distribution pour l'alimentation supérieure, la profondeur de ces nervures représente de préférence au moins la moitié de l'épaisseur de ladite électrode et la largeur de ces nervures représente au moins le tiers de la largeur de ces électrodes.

Grâce aux reliefs, notamment aux nervures, qui structurent la surface des électrodes de distribution, au moins dans les zones de cette surface qui sont en contact avec la couche transparente conductrice, on améliore la distribution du courant pour l'alimentation supérieure des diodes par augmentation de la surface de contact entre les électrodes de distribution et la couche transparente conductrice.

De préférence, les électrodes inférieures des diodes sont reliées électriquement auxdits moyens d'alimentation inférieure des diodes au travers de l'au moins une couche électriquement isolante et lesdites tranchées et/ou trous de connexion traversent également cette même couche électriquement isolante. On trouve alors généralement deux couches électriquement isolantes. La première couche électriquement isolante isole alors les moyens d'alimentation inférieure des diodes, comme par exemple une matrice active, des électrodes inférieures des diodes et du réseau d'électrodes de distribution pour l'alimentation supérieure des diodes. La deuxième couche électriquement isolante isole alors les électrodes inférieures des diodes des électrodes supérieures des diodes. Généralement, les électrodes inférieures des diodes sont alors situées dans le même plan que le réseau d'électrodes de distribution pour l'alimentation supérieure des diodes. Ces deux couches électriquement isolantes recouvrent bien à la fois les moyens d'alimentation inférieure des diodes et le réseau d'électrodes de distribution pour l'alimentation supérieure des diodes.

De préférence, lesdites tranchées ou trous de connexion découvrent ces électrodes sur toute leur épaisseur et la largeur desdites tranchées ou trous de connexion, évaluée au fond de ces tranchées et/ou de ces trous, est supérieure d'au moins un tiers à la largeur desdites électrodes, de manière à ménager, de part et d'autre de chaque électrode, des cavités. Des telles cavités concourent également avantageusement à l'augmentation de la surface de contact entre les électrodes de distribution et la couche transparente conductrice.

De préférence, la profondeur desdites tranchées et/ou desdits trous de connexion est supérieure à l'épaisseur desdites électrodes de distribution.

De préférence, ladite couche organique électroluminescente comprenant lesdites éléments de couche insérés entre les électrodes de chaque diode recouvre, en une ou plusieurs zones, l'ensemble de la surface active du panneau et recouvre également lesdites tranchées et/ou lesdits trous de connexion. Grâce à la structuration de la surface des électrodes apportée par les reliefs, notamment des nervures, et/ou les cavités au fond des tranchées et/ou des trous de connexion, on constate que la couche organique électroluminescente ne recouvre pas complètement la surface des électrodes de distribution pour l'alimentation supérieure des diodes, ou qu'elle est rompue par endroits, de sorte que des zones de contact électrique direct sont ménagés entre ces électrodes et la couche transparente conductrice. Tout autre moyen de structuration de la surface des électrodes que les nervures ou les cavités peut être utilisé sans se départir de l'invention, pourvu qu'il apporte cet effet technique de non-recouvrement ou de rupture.

De préférence, l'épaisseur de ladite couche organique électroluminescente est inférieure à la profondeur desdits reliefs, notamment desdites nervures, et/ou, le cas échéant, desdites cavités.

De préférence, lesdits moyens d'alimentation inférieure des diodes comprennent au moins un réseau d'électrodes, dont un réseau d'électrodes d'alimentation inférieure des diodes et, le cas échéant, des circuits de commande des diodes comprenant eux-mêmes des éléments tels des transistors et/ou des condensateurs, et des plots conducteurs pour connecter ces éléments.

En résumé, l'invention a pour objet un panneau à matrice active intégrant un réseau d'électrodes de distribution pour l'alimentation supérieure des diodes reliées aux électrodes supérieures transparentes des diodes, où, grâce à une texturation de la surface de ces électrodes de distribution, notamment par des nervures, on améliore le contact électrique entre ces électrodes de distribution et les électrodes supérieures transparentes.

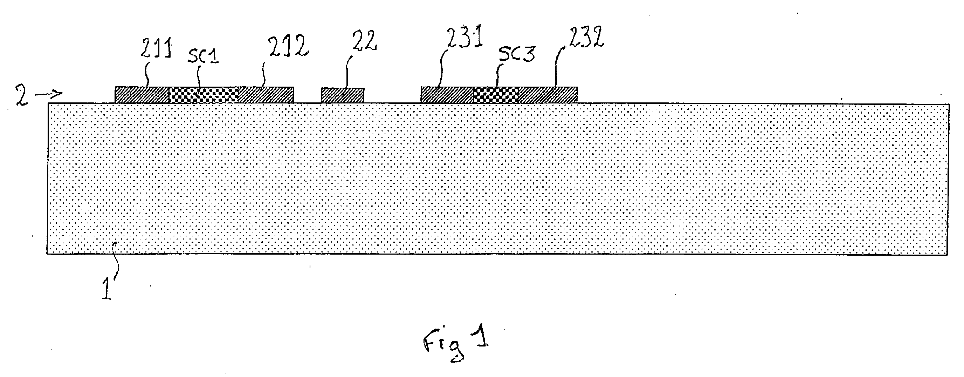

L'invention sera mieux comprise à la lecture de la description qui va suivre, donnée à titre d'exemple non limitatif, et en référence aux figures 1 à 10 annexées qui décrivent des étapes successives de fabrication d'un panneau de diodes, selon un mode de réalisation de l'invention.

On va maintenant décrire un mode de réalisation selon l'invention d'un panneau de diodes organiques électroluminescentes ; à chaque diode du panneau est associée un circuit de commande, comprenant notamment deux transistors à effet de champ (FET ou « Field Effect Transistor » en langue anglaise) ; de tels circuits sont connus en eux-mêmes et ne seront pas décrits ici en détail ; chaque diode comprend une électrode inférieure 832 et une électrode supérieure 132, transparente, et une zone de couche organique électroluminescente intercalée entre ces électrodes ; le panneau comprend également plusieurs réseaux d'électrodes, notamment pour l'adressage des circuits de commande, pour la sélection des circuits de commande, et pour l'alimentation des diodes ; on compte notamment un réseau d'électrodes d'alimentation inférieure des diodes, connu en lui-même, qui ne sera pas décrit ici en détail ; on compte également un réseau d'électrodes de distribution pour l'alimentation supérieure des diodes, qui sera décrit en détail ci-après et dont les électrodes sont reliées aux électrodes supérieures des diodes ; tous ces circuits de commande, avec notamment leurs transistors, et tous ces réseaux d'électrodes sont intégrés à la matrice de commande et d'alimentation des diodes intercalée entre un substrat 1 et les diodes elles-mêmes. Il s'agit ici d'une matrice dite « active » puisqu'elle intègre des circuits de commande.

En référence à la figure 1, sur un substrat isolant 1 de bonne planéité, après avoir déposé des plots semi-conducteurs SC1, SC3 aux emplacements des transistors à effet de champ TFT1, TFT2, on dépose les plots de drain et de source de ces transistors, 211 et 212 pour le transistor TFT1, 231 et 232 pour le transistor TFT3, et une électrode 22 de l'un des réseaux intégrés à la matrice de commande et d'alimentation. Pour ces dépôts, on procède d'une manière connue en elle-même, par exemple par évaporation sous vide du métal des électrodes avec un masque adapté.

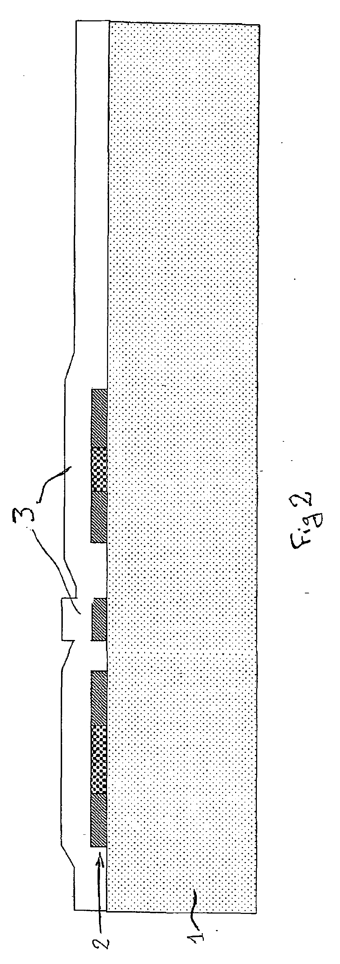

En référence à la figure 2, d'une manière connue en elle-même, on dépose ensuite une couche isolante de grille 3, par exemple en nitrure de silicium, qui recouvre l'ensemble de la matrice active d'une épaisseur approximativement uniforme.

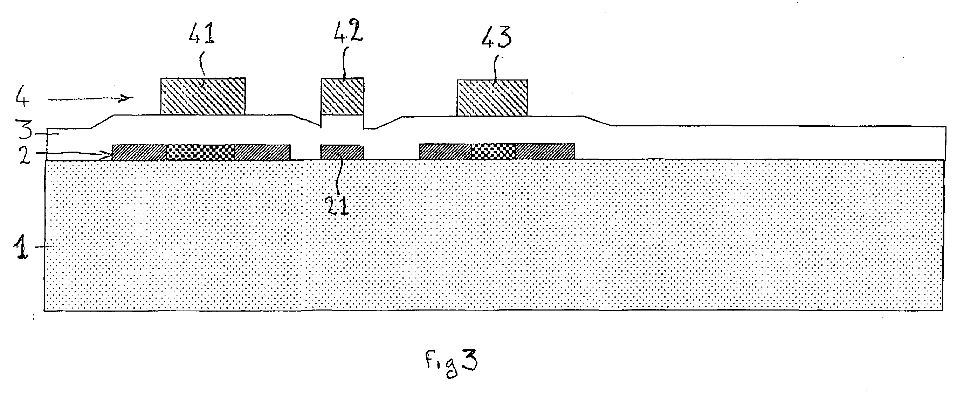

En référence à la figure 3, en interposant à nouveau un masque adapté d'évaporation sous vide, en une seule étape, on dépose les plots conducteurs de grilles des transistors, 41 pour le transistor TFT1, 43 pour le transistor TFT2, et une électrode 42 (ou un plot conducteur) positionné au dessus de l'électrode 21 ; cette électrode 42 (ou ce plot) sont des conducteurs intégrés à la matrice de commande et d'alimentation.

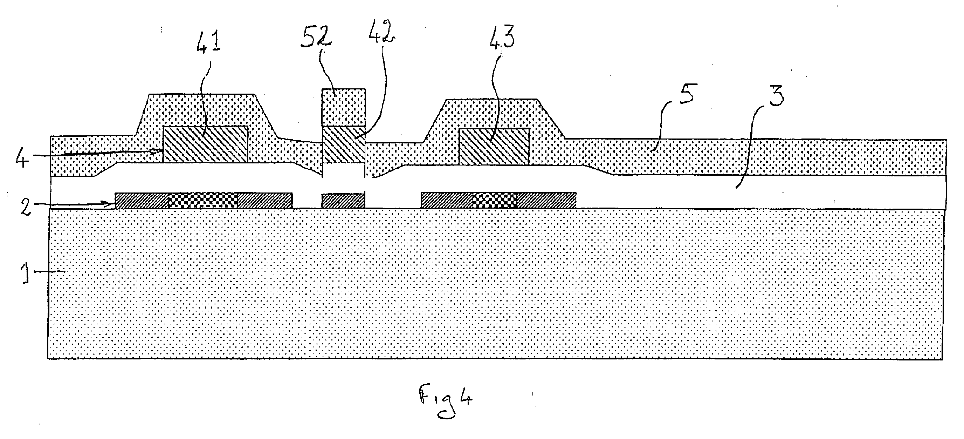

En référence à la figure 4, d'une manière connue en elle-même, on dépose ensuite une couche diélectrique de recouvrement 5, par exemple en silice, qui recouvre l'ensemble de la matrice active d'une épaisseur approximativement uniforme ; lors de cette opération, l'électrode 42 (ou plot) est ainsi recouvert d'un plot isolant 52.

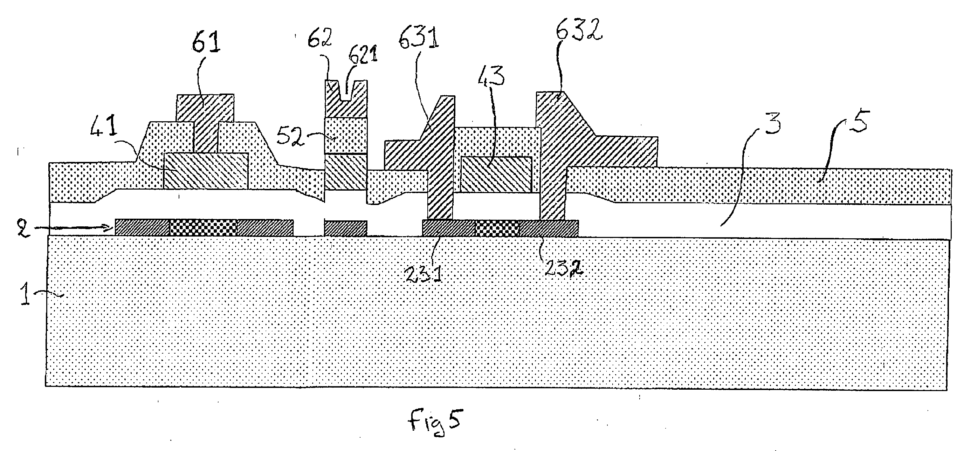

En référence à la figure 5, après avoir, d'une manière connue en elle-même et en une seule opération, percé des trous de connexion jusqu'au plot de grille 41 du transistor TFT1 à travers la couche diélectrique de recouvrement 5, et jusqu'aux plots de drain et de source 231 et 232 du transistor TFT3 à travers la couche diélectrique de recouvrement 5 et la couche isolante de grille 3, on dépose, en une autre opération, d'une part des plots conducteurs traversants ces trous (« via ») : 61 pour la connexion-de grille du transistor TFT1, 631 et 632 pour les connexions de source et de drain du transistor TFT3, d'autre part le réseau des électrodes de distribution pour l'alimentation supérieure des diodes, représenté ici par l'électrode 62. L'épaisseur de ces plots conducteurs et de ces électrodes est de préférence comprise entre 350 et 600 nm. Au centre de la face supérieure de l'électrode 62, par gravure humide, on pratique une nervure 621 dont la fonction sera précisée ultérieurement ; tout autre structuration de l'électrode 62 qu'une nervure peut être réalisée sans se départir de l'invention, du moment qu'on obtient une augmentation de la surface de contact de cette électrode 62 ; la profondeur de cette nervure représente de préférence au moins la moitié de l'épaisseur de l'électrode 62, de façon à ce que la « marche » ainsi ménagée dans la face supérieure de l'électrode soit suffisante pour rompre la couche organique électroluminescente 10 déposée ultérieurement de manière à laisser le métal de cette électrode partiellement à nu sur cette face supérieure ; la largeur de cette nervure représente de préférence au moins le tiers de la largeur de l'électrode 62 de manière à ménager un volume suffisant pour recueillir le matériau de la couche organique 10 et de façon à ce que cette électrode offre une surface de contact suffisante pour l'électrode supérieure 11, notamment quand on ne décape pas la couche organique 10 après son dépôt.

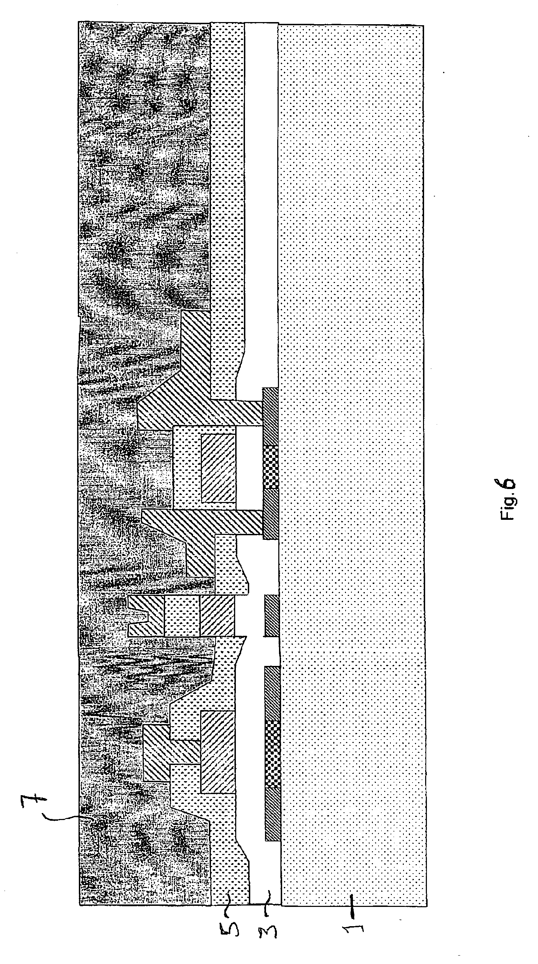

En référence à la figure 6, on dépose ensuite sur l'ensemble de la surface de la matrice active une couche de planéité 7, isolante électriquement et adaptée, notamment en épaisseur, pour aplanir les reliefs formés par les électrodes, circuits et transistors intégrés à la matrice de commande et d'alimentation.

En référence à la figure 7, après avoir, d'une manière connue en elle-même et en une seule opération, percé des trous de connexion à travers la couche de planéité 7 jusqu'aux plots conducteurs traversants 632 reliés aux drains 232 des transistors TFT3, on dépose, en utilisant un masque approprié, les électrodes inférieures des diodes 832 qui comblent ces trous de connexion ; le masque de dépôt est adapté pour obtenir la surface requise de ces électrodes inférieures.

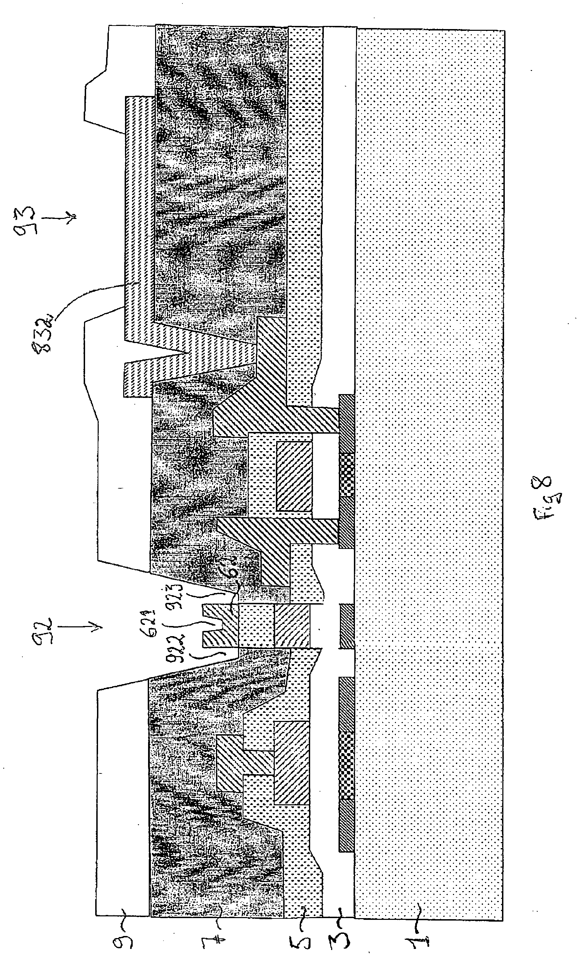

En référence à la figure 8, on dépose ensuite sur l'ensemble de la surface de la matrice active une couche d'isolation 9, destinée à isoler électriquement les électrodes inférieures et les électrodes supérieures des diodes. On ménage ensuite dans cette couche, d'une part des tranchées de connexion 92 pour découvrir totalement les électrodes 62 de distribution pour l'alimentation supérieure des diodes, d'autre part des épargnes 93 de manière à découvrir les électrodes inférieures 832 des diodes sur une surface correspondant à la surface de zone émissive souhaitée pour chaque diode ; compte tenu de l'épaisseur cumulée des couches de planéité 7 et d'isolation 9, la profondeur des tranchées 92 est très supérieure à l'épaisseur des électrodes 62 ; de préférence, les tranchées de connexion 92 découvrent les électrodes 92 sur toute leur épaisseur et la largeur de ces tranchées de connexion 92, évaluée au fond, est supérieure d'au moins un tiers à la largeur des électrodes 62, de manière à ménager, de part et d'autre de chaque électrode 62, des cavités 922, 923 situées entre cette électrode 62 et un versant de la tranchée de connexion 92 de manière à ménager un volume suffisant pour recueillir le matériau de la couche organique et de façon, également, à offrir une surface de contact suffisante pour l'électrode supérieure, notamment quand on ne décape pas la couche organique 10 après son dépôt.

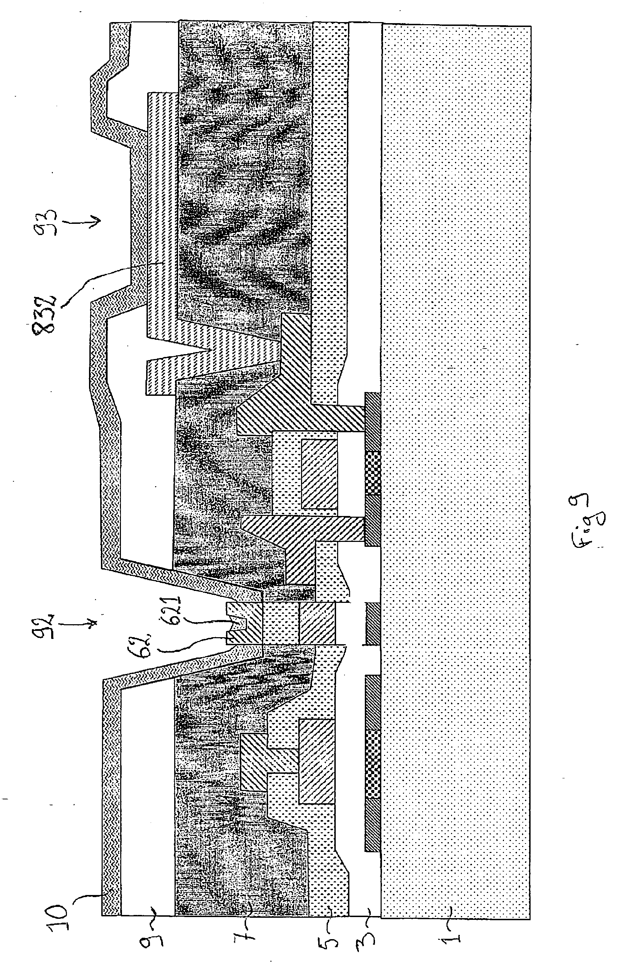

En référence à la figure 9, on dépose ensuite une couche organique électroluminescente 10 sur l'ensemble de la surface de la matrice active, de manière, notamment, à recouvrir la partie découverte des électrodes inférieures 932 des diodes à travers les épargnes 93 ; cette couche organique électroluminescente 10 se décompose généralement en plusieurs sous-couches, notamment une sous-couche émissive, et des sous-couches de transport et d'injection de charges de part et d'autre de la sous-couche émissive ; lorsque les diodes présentent différentes couleurs d'émission, on dépose des couches organiques électroluminescentes différentes suivant la couleur d'émission des différentes zones du panneau. L'épaisseur de la couche organique électroluminescente 10 est généralement inférieure à 150 nm, c'est-à-dire très largement inférieure à l'épaisseur cumulée des couches de planéité 7 et d'isolation 9, c'est-à-dire aussi inférieure à l'épaisseur des électrodes 62 de distribution pour l'alimentation supérieure des diodes ; comme illustré par la figure 9, le matériau de la couche électroluminescente se déverse dans les cavités 922, 923 ménagées entre les électrodes 62 et les versants des tranchées de connexion 92 dans lesquelles ces électrodes 62 sont insérées, et/ou se déverse dans les nervures 621 pratiquées dans l'épaisseur de ces électrodes 62, et une partie importante de la surface des électrodes 62 n'est pas recouverte par la couche organique électroluminescente ; grâce à la structuration de surface apportée par les cavités 922, 923, les nervures 621, et aussi à la pente des versants des tranchées de connexion 92, on constate que la couche organique électroluminescente 10 se rompt et laisse à nu une partie importante de la surface des électrodes 62 ; cette partie des électrodes qui n'est pas recouverte et reste « à nu » est donc disponible immédiatement pour un contact électrique avec la couche d'électrodes supérieures ; on est donc en mesure de déposer la couche d'électrodes supérieure en évitant une étape intermédiaire d'élimination de la couche organique électroluminescente 10 à l'endroit de ces électrodes, contrairement au procédé décrit dans le document EP1489671 (voir notamment figure 7E de ce document). Pour augmenter l'effet technique de non recouvrement et de « mise à nu », il est préférable que l'épaisseur de couche organique électroluminescente 10 soit inférieure à la profondeur de ces cavités 922, 923 et/ou de ces nervures 621 ; tout autre moyen de structuration de la surface des électrodes 62 que les nervures ou les cavités peut être utilisé sans se départir de l'invention, pourvu qu'il apporte l'effet technique d'augmentation de la surface de contact, et, notamment, de non recouvrement et de « mise à nu ».

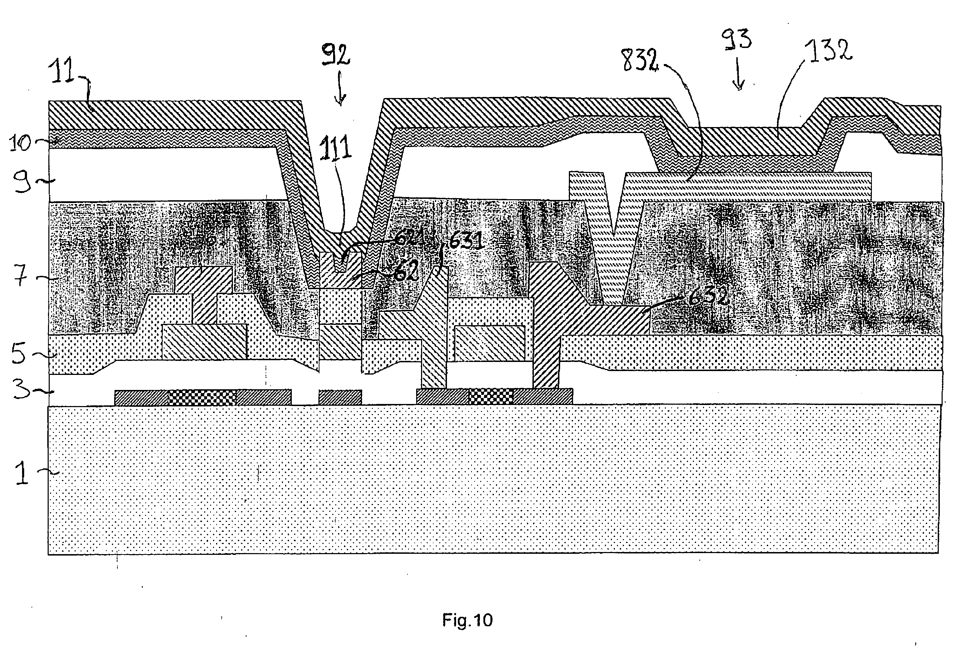

En référence à la figure 10, on dépose ensuite une couche conductrice transparente 11, par exemple en ITO (« Indium Tin Oxide ») par pulvérisation cathodique sous vide, recouvrant d'une épaisseur sensiblement uniforme l'ensemble de la matrice active, et notamment les tranchées 92 et les épargnes 93 ; contrairement à ce qu'indique la figure 10, l'épaisseur de cette couche 11 est généralement inférieure à l'épaisseur de la couche organique électroluminescente 10 ; à l'endroit des épargnes 93, on forme ainsi les diodes électroluminescente comprenant une électrode supérieure 132 dans une zone de la couche 11 et une électrode inférieure 832 et une zone de la couche organique électroluminescente 10 intercalée entre ces électrodes ; à l'endroit des tranchées 92, on assure le contact électrique 111 entre les électrodes 62 intégrées à la matrice active et la couche conductrice transparente 11 , via les parties découvertes de ces électrodes ; selon une variante, les tranchées de connexion 92 sont remplacées par des séries de trous de connexion disposées le long des électrodes 62 ; le contact entre la couche 11 et les électrodes 62 est alors assuré au niveau de ces trous de connexion. On voit que, dans ce mode de réalisation, toutes les électrodes supérieures des diodes du panneau sont reliées au même potentiel. Selon une variante, on peut prévoir une couche conductrice transparente 11 divisée en bandes électriquement isolées s'étendant parallèlement aux électrodes 62 de distribution pour l'alimentation supérieure des diodes ; chaque électrode 62 permet le contrôle de l'alimentation de toutes les diodes recouverte de la même bande conductrice transparente, indépendamment des diodes recouvertes par d'autres bandes. Après le dépôt de la couche conductrice transparente 11, on procède aux opérations habituelles d'encapsulation qui ne seront pas décrite ici en détail.

**On obtient ainsi un panneau de diodes organiques électroluminescente selon l'invention** comprenant des moyens d'alimentation inférieure des diodes et un réseau d'électrodes 62 de distribution pour l'alimentation supérieure des diodes ; ces électrodes 62 sont insérées dans le fond de tranchées 92 ménagées dans l'épaisseur de couches électriquement isolantes 7, 9 ; chaque diode comprend une électrode supérieure transparente qui s'étend jusqu'au fond d'une tranchée 92 pour venir se relier électriquement à une électrode 62 ; en dehors des tranchées 92, une couche organique électroluminescente 10 sépare l'électrode supérieure transparente des couches électriquement isolantes 7, 9. Les moyens d'alimentation inférieure des diodes comprennent ici les circuits de commande des diodes et le réseau des électrodes d'alimentation inférieure des diodes.

La présente invention a été décrite en se référant à un panneau de diodes à matrice active ; il est évident pour l'homme du l'art qu'elle peut s'appliquer à d'autres types de panneaux de diodes, notamment des panneaux à matrice passive, sans sortir du cadre des revendications ci-après.

## Revendications

1. Panneau de diodes organiques électroluminescentes, où chaque diode comprend une électrode inférieure (832) et une électrode supérieure (132), entre lesquelles est inséré un élément de couche organique électroluminescente (10) qui est en contact électrique avec lesdites électrodes (832, 132), ledit panneau comprenant un substrat (1) supportant :
- des moyens d'alimentation inférieure des diodes qui sont reliés électriquement aux électrodes inférieures (832) des diodes, et un réseau d'électrodes (62) de distribution pour l'alimentation supérieure des diodes qui sont reliées électriquement aux électrodes supérieures des diodes,
- au moins une couche électriquement isolante (7, 9) recouvrant lesdits moyens d'alimentation inférieure des diodes et ledit réseau d'électrodes (62) de distribution pour l'alimentation supérieure des diodes,
- des tranchées (92) et/ou des trous de connexion pratiqués dans l'au moins une couche électriquement isolante (7, 9) pour dégager au moins partiellement de ladite couche électriquement isolante (7, 9) les électrodes (62) de distribution pour l'alimentation supérieure des diodes,
- une couche transparente conductrice (11) recouvrant, en une ou plusieurs zones, les zones dans lesquelles la couche organique électroluminescente (10) est en contact électrique avec les électrodes inférieures (832) des diodes, où chaque zone de couche transparente conductrice (11) s'étend jusque dans au moins une desdites tranchées (92) et/ou au moins un desdits trous de connexion de manière à assurer un contact électrique avec au moins une desdites électrodes (62) de distribution pour l'alimentation supérieure des diodes,
**caractérisé en ce que** lesdites électrodes (62) de distribution pour l'alimentation supérieure des diodes présentent des reliefs, notamment des nervures (621), sur la face de ces électrodes de distribution (62) qui est en contact électrique avec ladite couche transparente conductrice (11).

2. Panneau selon la revendication 1 **caractérisé en ce que** lesdits reliefs sont adaptés pour augmenter la surface de contact électrique entre les électrodes (62) de distribution pour l'alimentation supérieure des diodes et la couche transparente conductrice (11).

3. Panneau selon l'une quelconque des revendications précédentes **caractérisé en ce que** la profondeur desdits reliefs, notamment des nervures (621), représente au moins la moitié de l'épaisseur de ladite électrode (62) de distribution pour l'alimentation supérieure des diodes.

4. Panneau selon l'une quelconque des revendications précédentes **caractérisé en ce que** les électrodes inférieures (832) des diodes sont reliées électriquement aux dits moyens d'alimentation inférieure des diodes au travers de l'au moins une couche électriquement isolante (7) et **en ce que** lesdites tranchées (92) et/ou trous de connexion traversent également cette même couche électriquement isolante (9).

5. Panneau selon l'une quelconque des revendications précédentes **caractérisé en ce que** lesdites tranchées (92) et/ou trous de connexion découvrent ces électrodes (62) sur toute leur épaisseur et **en ce que** la largeur desdites tranchées (92) et/ou trous de connexion, évaluée au fond de ces tranchées (92) et/ou de ces trous, est supérieure d'au moins un tiers à la largeur desdites électrodes (62), de manière à ménager, de part et d'autre de chaque électrode (62), des cavités (922, 923).

6. Panneau selon l'une quelconque des revendications précédentes **caractérisé en ce que** la profondeur desdites tranchées (92) et/ou desdits trous de connexion est supérieure à l'épaisseur desdites électrodes (62) de distribution pour l'alimentation supérieure des diodes.

7. Panneau selon l'une quelconque des revendications précédentes **caractérisé en ce que** ladite couche organique électroluminescente (10) comprenant lesdits éléments de couche insérés entre les électrodes (832, 132) de chaque diode recouvre, en une ou plusieurs zones, l'ensemble de la surface active du panneau et recouvre également lesdites tranchées (92) et/ou lesdits trous de connexion.

8. Panneau selon la revendication 7 **caractérisé en ce que** l'épaisseur de ladite couche organique électroluminescente (10) est inférieure à la profondeur desdits reliefs, notamment desdites nervures (621).

9. Panneau selon l'une quelconque des revendications précédentes **caractérisé en ce que** lesdits moyens d'alimentation inférieure des diodes comprennent au moins un réseau d'électrodes, dont un réseau d'électrodes d'alimentation inférieure des diodes et, le cas échéant, des circuits de commande des diodes comprenant eux-mêmes des éléments tels des transistors et/ou des condensateurs, et des plots conducteurs (61, 631, 632) pour connecter ces éléments.

## Claims

1. A panel of organic light-emitting diodes, in which each diode comprises a lower electrode (832) and an upper electrode (132), between which an organic electroluminescent layer element (10) is inserted which is in electrical contact with said electrodes (832, 132), said panel comprising a substrate (1) supporting:
- lower supply means of the diodes, which are electrically connected to the lower electrodes (832) of the diodes, and a network of distribution electrodes (62) for the upper supply of the diodes, which are electrically connected to the upper electrodes of the diodes,
- at least one electrically insulating layer (7, 9) covering said lower supply means of the diodes and said network of distribution electrodes (62) for the upper supply of the diodes,
- connection trenches (92) and/or connection holes made in the at least one electrically insulating layer (7, 9) in order to uncover the distribution electrodes (62) for the upper supply of the diodes at least partially from said electrically insulating layer (7, 9),
- a transparent conductive layer (11) covering, in one or more zones, the zones in which the organic electroluminescent layer (10) is in electrical contact with the lower electrodes (832) of the diodes, in which each transparent conductive layer zone (11) extends into at least one of said connection trenches (92) and/or at least one of said connection holes so as to ensure electrical contact with at least one of said distribution electrodes (62) for the upper supply of the diodes,
**characterized in that** said distribution electrodes (62) for the upper supply of the diodes have reliefs, in particular ribs (621), on that face of these distribution electrodes (62) which is in electrical contact with said transparent conductive layer (11).

2. The panel as claimed in claim 1, **characterized in that** said reliefs are adapted to increase the electrical contact area between the distribution electrodes (62) for the upper supply of the diodes and the transparent conductive layer (11).

3. The panel as claimed in either one of the preceding claims, **characterized in that** the depth of said reliefs, in particular the ribs (621), represents at least half of the thickness of said distribution electrode (62) for the upper supply of the diodes.

4. The panel as claimed in any one of the preceding claims, **characterized in that** the lower electrodes (832) of the diodes are electrically connected to said lower supply means of the diodes through the at least one electrically insulating layer (7), and **in that** said connection trenches (92) and/or connection holes also pass through this same electrically insulating layer (7).

5. The panel as claimed in any one of the preceding claims, **characterized in that** said connection trenches (92) and/or connection holes uncover these electrodes (62) over their entire thickness, and **in that** the width of said connection trenches (92) and/or connection holes, evaluated at the bottom of these connection trenches (92) and/or these holes, is at least one third more than the width of said electrodes (62), so as to form cavities (922, 923) on either side of each electrode (62).

6. The panel as claimed in any one of the preceding claims, **characterized in that** the depth of said connection trenches (92) and/or connection holes is greater than the thickness of said distribution electrodes (62) for the upper supply of the diodes.

7. The panel as claimed in any one of the preceding claims, **characterized in that** said organic electroluminescent layer (10) comprising said layer elements inserted between the electrodes (832, 132) of each diode covers, in one or more zones, the entire active surface of the panel and also covers said connection trenches (92) and/or said connection holes.

8. The panel as claimed in claim 7, **characterized in that** the thickness of said organic electroluminescent layer (10) is less than the depth of said reliefs, in particular said ribs (621).

9. The panel as claimed in any one of the preceding claims, **characterized in that** said lower supply means of the diodes comprise at least one network of electrodes, including a network of lower supply electrodes of the diodes and optionally drive circuits of the diodes, themselves comprising elements such as transistors and/or capacitors, and conductive pads (61, 631, 632) for connecting these elements.

## Patentansprüche

1. Tafel mit organischen, Licht emittierenden Dioden, bei der jede Diode eine untere Elektrode (832) und eine obere Elektrode (132) umfasst, zwischen die ein organisches, Licht emittierendes Schichtelement (10) eingefügt ist, das die Elektroden (832, 132) elektrisch kontaktiert, wobei die Tafel ein Substrat (1) umfasst, das Folgendes trägt:
- Mittel für die von unten erfolgende Diodenspeisung, welche elektrisch mit den unteren Elektroden (832) der Dioden verbunden sind, und ein Gitter aus Verteilungselektroden (62) für die von oben erfolgende Diodenspeisung, welche elektrisch mit den oberen Elektroden der Dioden verbunden sind,
- mindestens eine elektrisch isolierende Schicht (7, 9), welche die Mittel für die von unten erfolgende Diodenspeisung und das Gitter aus Verteilungselektroden (62) für die von oben erfolgende Diodenspeisung überdeckt,
- Verbindungsgräben (92) und/oder Verbindungslöcher, die in der mindestens einen elektrisch isolierenden Schicht (7, 9) ausgebildet sind, um die Verteilungselektroden (62) für die von oben erfolgende Diodenspeisung mindestens teilweise von der elektrisch isolierenden Schicht (7, 9) zu befreien,
- eine transparente leitende Schicht (11), die ganz oder bereichsweise die Bereiche überdeckt, in denen die organische, Licht emittierende Schicht (10) die unteren Elektroden (832) der Dioden elektrisch kontaktiert, wobei jeder Bereich der transparenten leitenden Schicht (11) sich bis in mindestens einen der Verbindungsgräben (92) und/oder mindestens eines der Verbindungslöcher derart erstreckt, dass mit mindestens einer der Verteilungselektroden (62) für die von oben erfolgende Diodenspeisung ein elektrischer Kontakt sichergestellt ist,
**dadurch gekennzeichnet, dass** die Verteilungselektroden (62) für die von oben erfolgende Diodenspeisung Erhebungen, insbesondere Rippen (621) auf der Fläche dieser Verteilungselektroden (62), welche die transparente leitende Schicht (11) elektrisch kontaktiert, aufweisen.

2. Tafel nach Anspruch 1, **dadurch gekennzeichnet, dass** die Erhebungen geeignet sind, die Fläche der elektrischen Kontaktierung zwischen den Verteilungselektroden (62) für die von oben erfolgende Diodenspeisung und der transparenten leitenden Schicht (11) zu vergrößern.

3. Tafel nach einem beliebigen der vorhergehenden Ansprüche, **dadurch gekennzeichnet, dass** die Tiefe der Erhebungen, insbesondere der Rippen (621), mindestens die Hälfte der Dicke der Verteilungselektrode (62) für die von oben erfolgende Diodenspeisung darstellt.

4. Tafel nach einem beliebigen der vorhergehenden Ansprüche, **dadurch gekennzeichnet, dass** die unteren Elektroden (832) der Dioden elektrisch mit den Mitteln für die von unten erfolgende Diodenspeisung durch die mindestens eine elektrisch isolierende Schicht (7) hindurch verbunden sind und dass sich die Verbindungsgräben (92) und/oder Verbindungslöcher ebenfalls durch dieselbe elektrisch isolierende Schicht (7) durchziehen.

5. Tafel nach einem beliebigen der vorhergehenden Ansprüche, **dadurch gekennzeichnet, dass** die Verbindungsgräben (92) und/oder Verbindungslöcher diese Elektroden (62) auf ihrer gesamten Dicke freilegen und dass die am Boden der Verbindungsgräben (92) und/oder Verbindungslöcher gemessen Breite dieser Verbindungsgräben (92) und/oder Verbindungslöcher die Breite der Elektroden (62) um mindestens ein Drittel übersteigt, so dass beidseitig jeder Elektrode (62) Hohlräume (922, 923) ausgebildet werden.

6. Tafel nach einem beliebigen der vorhergehenden Ansprüche, **dadurch gekennzeichnet, dass** die Tiefe der Verbindungsgräben (92) und/oder Verbindungslöcher größer ist als die Dicke der Verteilungselektroden (62) für die von oben erfolgende Diodenspeisung.

7. Tafel nach einem beliebigen der vorhergehenden Ansprüche, **dadurch gekennzeichnet, dass** die organische, Licht emittierende Schicht (10), welche die zwischen die Elektroden (832, 132) jeder Diode eingefügten Schichtelemente umfasst, ganz oder bereichsweise die gesamte aktive Fläche der Tafel sowie die Verbindungsgräben (92) und/oder Verbindungslöcher überdeckt.

8. Tafel nach Anspruch 7, **dadurch gekennzeichnet, dass** die Dicke der organischen, Licht emittierenden Schicht (10) geringer ist als die Tiefe der Erhebungen, insbesondere der Rippen (621).

9. Tafel nach einem beliebigen der vorhergehenden Ansprüche, **dadurch gekennzeichnet, dass** die Mittel für die von unten erfolgende Diodenspeisung mindestens ein Elektrodengitter, hierbei ein Gitter aus Elektroden für die von unten erfolgende Diodenspeisung, und gegebenenfalls Diodenschaltkreise umfassen, die wiederum Elemente wie Transistoren und/oder Kondensatoren und leitende Kontakte (61, 631, 632) umfassen, um diese Elemente zu verbinden.
